Europäisches Patentamt

European Patent Office

Office européen des brevets

(19)

(11) Veröffentlichungsnummer: **0 271 599 B1**

(12) ## EUROPÄISCHE PATENTSCHRIFT

(45) Veröffentlichungstag der Patentschrift: **04.09.91**

(51) Int. Cl.5: **H01L 29/52**, H01L 29/73, H01L 21/90

(21) Anmeldenummer: **86117692.3**

(22) Anmeldetag: **18.12.86**

(54) **Kollektorkontakt eines integrierten Bipolartransistors.**

(43) Veröffentlichungstag der Anmeldung:
22.06.88 Patentblatt 88/25

(45) Bekanntmachung des Hinweises auf die
Patenterteilung:
04.09.91 Patentblatt 91/36

(84) Benannte Vertragsstaaten:
**DE FR GB IT NL**

(56) Entgegenhaltungen:
**CH-A- 547 012**
**DE-A- 2 621 165**
**DE-B- 1 292 761**

**PATENT ABSTRACTS OF JAPAN, Band 10,**
**Nr. 376 (E-464)[2433], 13. Dezember 1986; &**
**JP-A-61 168 256**

(73) Patentinhaber: **Deutsche ITT Industries GmbH**
**Hans-Bunte-Strasse 19 Postfach 840**
**W-7800 Freiburg i.Br.(DE)**

(72) Erfinder: **Blossfeld, Lothar, Dipl.-Phys.**
**Waldstrasse 23**
**W-7801 Freiburg-Hochdorf(DE)**
Erfinder: **Volz, Christian, Dipl.-Phys.**
**Weidenmattenstrasse 16**
**W-7830 Emmendingen(DE)**

EP 0 271 599 B1

## Beschreibung

Die Erfindung beschäftigt sich mit der platzsparenden Kontaktierung eines integrierten Bipolartransistors. Bekanntlich werden die Kontakte an die Zonen in lateraler Erstreckung angebracht, wie es beispielsweise aus der Zeitschrift "Elektronik", 10 (18. 5.1984) Seiten 68 und 69 bekannt ist.

Aus der DE-A-26 21 165 ist ferner bekannt, die Kollektorzone an der Bodenfläche einer separaten U-förmigen Ausnehmung zu kontaktieren, die gegen die Basiszone isoliert ist.

Die Erfindung geht aus von einem aus der genannten DE-A-26 21 165 bekannten integrierten Bipolartransistor, dessen Kollektorzone des einen Leitungstyps an der einen Hauptfläche eines plattenförmigen Halbleitersubstrats aus Silizium des anderen Leitungstyps gegen die übrigen Bauelemente einer monolithisch integrierten Festkörperschaltung mittels eines Grabens, der die Kollektorzone vollständig umgibt, isoliert ist und einen Kollektorkontakt aufweist.

Aufgabe der Erfindung ist die Angabe einer platzsparenden Kontaktierung der Kollektorzone. Die Erfindung geht von dem Gedanken aus, den Kollektorkontakt vowiegend in vertikaler Erstreckung auszubilden.

Die oben genannte Aufgabe wird erfindungsgemäß dadurch gelöst, daß der Kollektorkontakt der Kollektorzone an der die Kollektorzone begrenzenden Seitenwand des Grabens angeordnet ist und aus einer Schicht aus polykristallinem Silizium des Leitungstyps der Kollektorzone besteht, daß der Kollektorkontakt eine in der Seitenfläche der Kollektorzone ausgebildete, hochdotierte Kontaktierungszone vom Leitungstyp der Kollektorzone bedeckt, daß die Bodenfläche des Grabens mit einer Siliziumdioxidschicht bedeckt ist und daß die Tiefe des Grabens mindestens gleich der Dicke der Kollektorzone ist.

Bei einer Weiterbildung des Bipolartransistors der Erfindung gemäß dem Anspruch 2 ist direkt unter der Siliziumdioxidschicht eine Leiterbahn aus dotiertem polykristallinem Silizium angeordnet, die auf einer weiteren Siliziumdioxidschicht angeordnet ist, die die Leiterbahn zusammen mit der auf der Bodenfläche des Grabens vorhandenen Siliziumdioxidschicht umgibt. Dadurch kann ohne zusätzlichen Platzaufwand ein in der Tiefe des Halbleiterkörpers verlegtes Leiternetzwerk erhalten werden, welches zur Abschirmung der einzelnen Komponenten der integrierten Schaltung oder auch zur Potentialversorgung der Komponenten dienen kann.

Ein Verfahren zur Herstellung des erfindungsgemäßen Bipolartransistors ist im Anspruch 3 angegeben und wird im Anspruch 4 weitergebildet.

Die Erfindung wird im folgenden anhand eines sich eng an das bekannte Verfahren der EP-A-0 071 665 anlehnenden Ausführungsbeispiel erläutert, welches mit diesem bekannten Verfahren kompatibel ist. Bei diesem bekannten Verfahren wird der Emitterbereich mittels einer Oxidationsmaskierungsschicht abgedeckt und nach Definition des Basisbereichs mittels einer Implantationsmaske unter Anwendung von zwei Ionen-Implantationsprozessen bei bestimmten unterschiedlichen Beschleunigungsspannungen eine Basiszone mit einer Basiskontaktierungszone gebildet.

Die Erfindung wird nun anhand der Figuren der Zeichnung näher erläutert.

Die Fig. 1 bis 7 zeigen nichtmaßstabsgerechte Schrägschliffansichten eines integrierten Bipolartransistors, die zur Veranschaulichung der aufeinanderfolgenden Verfahrensschritte des Verfahrens nach der Erfindung dienen,

Fig. 8 zeigt einen Grundriß, dessen Schnittansicht entlang der Linie S-S' aus der Fig. 7 ersichtlich ist, während

Fig. 9 zur Erläuterung einer Weiterbildung des Verfahrens nach der Erfindung dient.

Das im folgenden beschriebene Ausführungsbeispiel bezieht sich auf einen integrierten NPN-Bipolartransistor, der aufgrund seiner günstigen Hochfrequenz- bzw. Schaltereigenschaften bevorzugt wird. Natürlich kann auch bei entsprechender Wahl des anderen Leitungstyps bei Anwendung des Verfahrens nach der Erfindung ein Kollektorkontakt an einem integrierten PNP-Bipolartransistor angebracht werden.

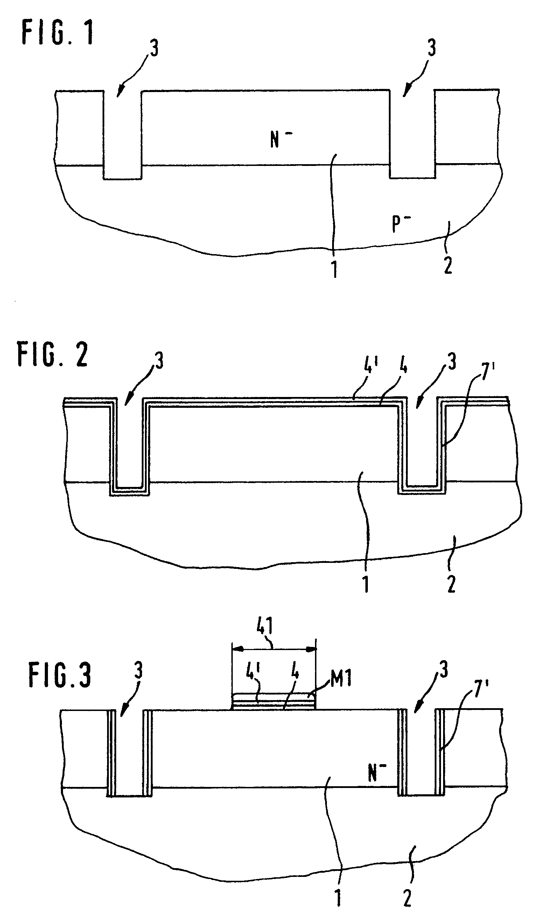

Bei dem bevorzugten Ausführungsbeispiel nach der Erfindung wird vom schwach dotierten p-leitenden Halbleitersubstrat 2 ausgegangen, an dessen einer Hauptfläche eine schwach n-leitende einkristalline Siliziumschicht, vorzugsweise durch Ionenimplantation, erzeugt ist. Die Kollektorzone 1 gemäß der Fig. 1 wird mittels anisotroper Ätzung des sie begrenzenden Grabens 3 durch die einkristalline Siliziumschicht hindurch ausgebildet. Die Tiefe des Grabens 3 muß mindestens gleich der Dicke der Kollektorzone 1 sein, um die elektrische Trennung des herzustellenden Bipolartransistors von den Komponenten der übrigen integrierten Festkörperschaltung zu gewährleisten.

Anisotrope Ätzverfahren, welche ausschließlich aus der Gasphase erfolgen, sind zur Ätzung von Halbleitermaterial sowie Siliziumdioxid und Siliziumnitrid bereits allgemein bekannt und werden daher nicht im einzelnen beschrieben.

Nach der Herstellung der Kollektorzone 1 werden, wie die Fig. 2 zeigt, die freiliegenden Oberflächenteile der Hauptfläche des Halbleitersubstrats 1 einschließlich der Oberflächenteile des Grabens 3

mit einer thermisch gewachsenen Dioxidschicht 4 bedeckt. Diese enthält die Seitenwand-Dioxidschicht 7'. Auf die thermisch gewachsene Dioxidschicht 4 wird die Siliziumnitridschicht 4' aufgebracht. Anschließend erfolgt eine anisotrope Nitridätzung, also eine gerichtete Ätzung der Siliziumnitridschicht derart, daß die Nitridschichtteile auf der Hauptfläche und der Bodenfläche des Grabens 3 entfernt werden, soweit diese nicht maskiert wurden.

Die Maskierung von Schichtteilen der Schichtenfolge 4, 4' ergibt die Möglichkeit, einen Kontaktierungsbereich der Kollektorelektrode an der Hauptfläche und dem Emitterbereich von einer thermisch erzeugten Isolierschicht freizuhalten. Damit wird bei geeigneter Dickenbemessung der Schichtenfolge 4, 4' das Verfahren der Erfindung mit dem bekannten Verfahren der genannten EP-A 0 071 665 kompatibel, in der die selbstjustierende Herstellung einer Emitterzone zu einer Basiszone mit einer diese einschließenden Basiskontaktierungszone beschrieben ist.

In diesem Zusammenhang wird also gemäß der Fig. 3 im Hinblick auf das Verfahren der EP-A-0 071 665 der Emitterbereich 41 und der in der Fig. 3 nicht angeschnittene Kollektorkontaktbereich gegen einen Ätzangriff mittels der Maskierungsschicht M1 aus Fotolack geschützt. Es erfolgt dann eine anisotrope Nitridätzung in bevorzugter Richtung senkrecht zur Hauptfläche, wobei die Nitridschicht an der Seitenwand des Grabens und natürlich unterhalb der Maskierungsschicht M1 erhalten bleibt. Anschließend erfolgt eine normale Dioxidätzung, bei der sowohl die Nitridschicht auf der Seitenwand des Grabens 3 als auch die Maskierungsschicht M1 maskiert und damit sowohl die Bodenfläche des Grabens 3 als auch das Halbleitermaterial um den Emitterbereich 41 und den Kollektorkontaktbereich freigelegt wird. Damit wird eine Anordnung gemäß der Schnittansicht der Fig. 3 erhalten.

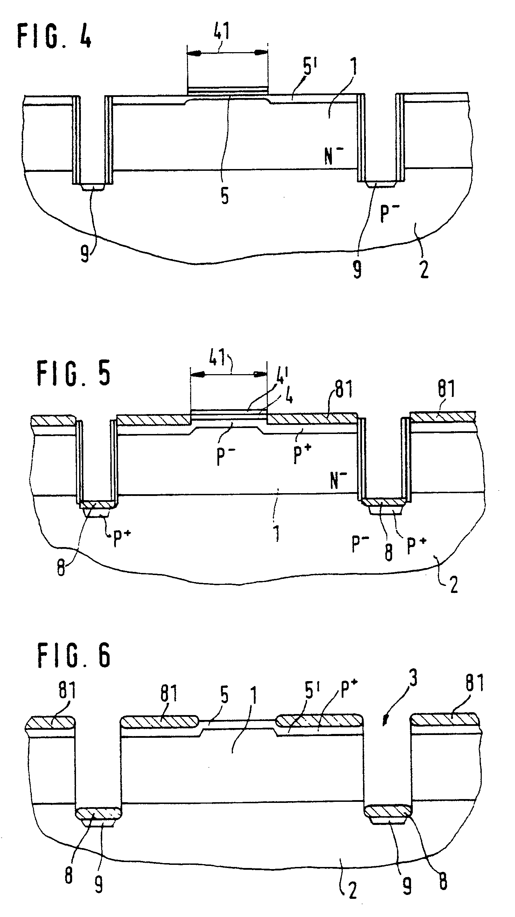

Zum Herstellen der unter der noch zu erzeugenden Emitterzone abgestuften Basiszone werden anschließend, wie in der genannten EP-A-0 071 665 im einzelnen geschildert wird, in die freiliegenden Teile der Halbleiteroberfläche Ionen des Leitungstyps des Halbleitersubstrats 2, also p-leitende, implantiert. Diese bilden am Boden des Grabens bei einer zur Aktivierung ausreichend hohen Temperatur die Kanalunterbrechungszone 9 gemäß der Fig. 4.

In Weiterbildung des Verfahrens nach der Erfindung im Hinblick auf das Verfahren der oben genannten EP-A-0 071 665 werden beim bevorzugten Ausführungsbeispiel der Erfindung in beliebiger Reihenfolge die Ionen des Substratleitungstyps das eine Mal bei einer solchen ersten Beschleunigungsspannung implantiert, das die Schichtenfolge Oxidschicht 4 und Nitridschicht 4' durchdrungen wird, und das andere Mal bei einer solchen zweiten Beschleunigungsspannung implantiert, daß die Schichtenfolge 4, 4' auf dem Emitterbereich und dem Kollektorkontaktbereich maskiert. Damit ergibt sich die in der Schnittansicht der Fig. 4 dargestellte Anordnung mit der aktiven Basiszone 5 und der Basiskontaktierungszone 5'. Vor der Implantation der p-dotierenden Verunreinigungen ist sorgfältig die Maskierungsschicht M1 zu entfernen.

Anschließend erfolgt eine thermische Oxidation, wobei sowohl auf der Bodenfläche des Grabens 3 die Isolierschicht 8 und an der Hauptfläche die Isolierschicht 81 gebildet wird, welche sich um den Emitterbereich 41 und den Kollektorkontaktbereich erstreckt. Damit wird eine Anordnung gemäß der Teilschnittansicht der Fig. 5 erhalten, wobei der Kollektorkontaktbereich hinter der Schnittfläche liegend zu denken ist.

Anschließend werden die auf dem Emitterbereich 41 der Seitenwandfläche noch verbliebenen Bereiche der Schichtenfolge 4, 4' unter Anwendung einer normalen Nitridätzung vor einer normalen Oxidätzung entfernt, wie die Fig. 6 veranschaulicht. Da die Oxidschicht 4 der Schichtenfolge 4, 4' wesentlich dünner ist als die Siliziumdioxidschichten 81 und 8, kann ein normaler, isotroper Ätzprozeß aus der Gasphase erfolgen, der rechtzeitig abgebrochen wird, so daß die Isolierschicht 8 am Boden des Grabens 3 und die Isolierschicht 81 außerhalb des Emitterbereichs 41 und außerhalb des Kollektorkontaktbereichs im wesentlichen erhalten bleibt.

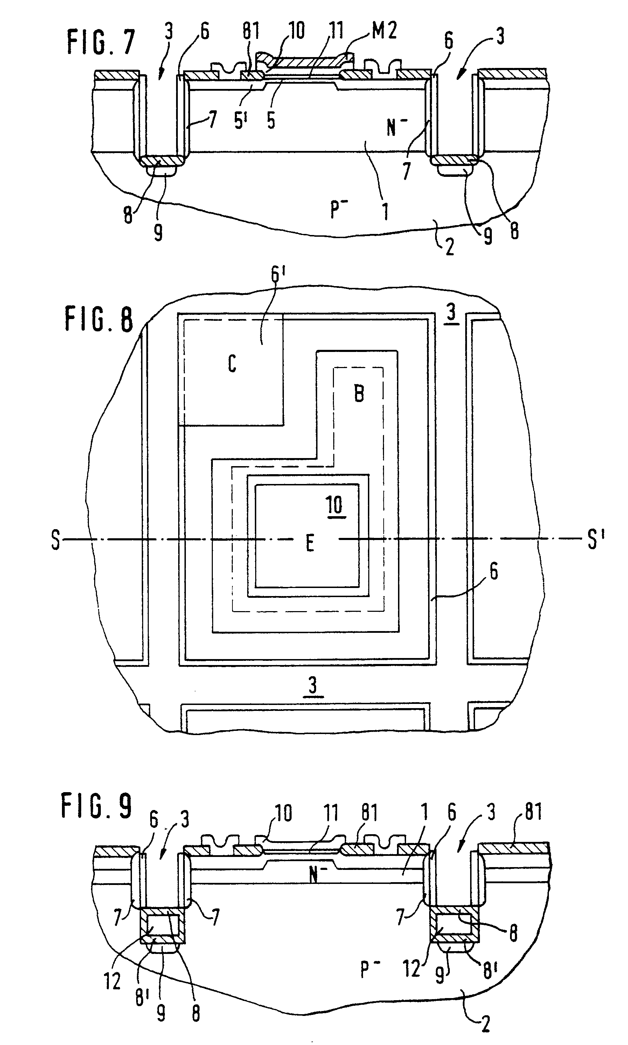

Nach der Nitridätzung und der Oxidätzung zum Entfernen der relativ dünnen Schichtenfolge 4, 4' an der Seitenwand des Grabens 3 und auf dem Emitterbereich 41 wird auf die Hauptfläche der Anordnung eine dotierte polykristalline Siliziumschicht aufgebracht, welche Dotierungen des Leitungstyps der Kollektorzone enthält, so daß ein Kollektorkontakt und/oder eine Emitterzone des Bipolartransistors herstellbar ist, deren Bereiche auf der polykristallinen Siliziumschicht mittels einer Ätzmaskierungsschicht, insbesondere aus Photolack, maskiert werden. Bei dem Ausführungsbeispiel wird gemäß Fig. 7 die Ätzmaske M2 verwendet, welche gemäß Fig. 8 auf der Hauptfläche einen Kontaktierungsbereich 6' der Kollektorelektrode und die Emitterelektrode 10 definiert, welche den Rand der außerhalb des Emitterbereichs 41 gebildeten Isolierschicht 81 überlappt. Bei einem folgenden Hochtemperaturprozeß werden aus den verbleibenden Teilen der n-dotierten polykristallinen Siliziumschicht verschiedene Zonen diffundiert; nämlich aus der Emitterelektrode 10 die Emitterzone 11, aus dem an der Hauptfläche liegenden Kontaktierungsteil 6' eine in Fig. 7 nicht angeschnittene Kollektorkontaktierungszone und aus dem an der Seitenfläche der Kollektorzone 1 liegenden Teil 6 die bandförmig ausgebildete Kollektorkontaktierungszone 7, welche die Kollektorzone 1 einrahmt. Diese Kollektorkontaktierungszone 7 bildet sowohl mit dem äußeren Basiszonenteil 5' als auch mit dem p-leitenden Halbleitersubstrat 2 je einen PN-Übergang.

Aufgrund der Seitenwandkontaktierung der Kollektorzone 1 ergibt sich eine äußerst platzsparende und niederohmige Kontaktierung. Es wird lediglich an der Hauptfläche die Kontaktierungsfläche C für eine Leiterbahn benötigt, welche so klein wie die Emitterkontaktierungsfläche E und die Basiskontaktierungsfläche B bemessen werden kann.

Die Kollektorkontaktierung kann auch, wie anhand der Fig. 9 erläutert wird, mittels der Leiterbahn 12 aus polykristallinem Silizium erfolgen, welche direkt unter der Siliziumdioxidschicht 8 an der Bodenfläche des Grabens 3 angeordnet ist.

Die Leiterbahn 12 aus dotiertem polykristallinem Silizium kann nach Erzeugen der Schichtenfolge 4, 4' gemäß Fig. 2 in den Graben 3 eingebracht werden und durch thermische Oxidation oberflächlich mit der weiteren Siliziumdioxidschicht 8' versehen werden, so daß sich eine zusätzliche Leiterbahnebene ergibt, die entweder zur Verbindung von Kollektorzonen oder auch zur elektrischen Abschirmung der Kollektorzonen gegeneinander auf Masser gelegt werden kann.

Die Gräben bzw. der Graben 3 kann durch Anwendung eines der bekannten Planarisierungsverfahren mit einem Isoliermaterial aufgefüllt werden, um eine ebene Verdrahtungsfläche für Leiterbahnen auf der Hauptfläche zu bilden.

## Patentansprüche

1. Integrierter Bipolartransistor, dessen Kollektorzone (1) des einen Leitungstyps an der einen Hauptfläche eines plattenförmigen Halbleitersubstrats (2) aus Silizium des anderen Leitungstyps gegen die übrigen Bauelemente einer monolithisch integrierten Festkörperschaltung mittels eines Grabens (3), der die Kollektorzone (1) vollständig umgibt, isoliert ist und einen Kollektorkontakt (6) aufweist, dadurch gekennzeichnet,
   - daß der Kollektorkontakt (6) der Kollektorzone (1) an der die Kollektorzone begrenzenden Seitenwand des Grabens (3) angeordnet ist und aus einer Schicht aus polykristallinem Silizium des Leitungstyps der Kollektorzone (1) besteht,
   - daß der Kollektorkontakt (6) eine in der Seitenfläche der Kollektorzone (1) ausgebildete, hochdotierte Kontaktierungszone (7) vom Leitungstyp der Kollektorzone (1) bedeckt,
   - daß die Bodenfläche des Grabens (3) mit einer Siliziumdioxidschicht (8) bedeckt ist und
   - daß die Tiefe des Grabens (3) mindestens gleich der Dicke der Kollektorzone (1) ist.

2. Bipolartransistor nach Anspruch 1, dadurch gekennzeichnet,
   - daß direkt unter der Siliziumdioxidschicht (8) eine Leiterbahn (12) aus dotiertem polykristallinem Silizium angeordnet ist, die auf einer weiteren Siliziumdioxidschicht (8') angeordnet ist, die die Leiterbahn (12) zusammen mit der auf der Bodenfläche des Grabens (3) vorhandenen Siliziumdioxidschicht (8) umgibt (Fig. 9).

3. Verfahren zum Herstellen eines integrierten Bipolartransistors nach Anspruch 1 oder 2, das folgende Verfahrenschritte aufweist:
   a) nach Ausbildung einer einkristallinen Siliziumschicht des einen Leitungstyps an der einen Hauptfläche des Halbleitersubstrats (2) vom anderen Leitungstyp wird mittels anisotroper Ätzung durch die Siliziumschicht hindurch ein Graben (3) gebildet und die Seitenfläche der Kollektorzone (1) freigelegt (Fig.1);
   b) danach werden die Oberflächenteile der Hauptfläche des Halbleitersubstrats (2) einschließlich der Oberflächenteile des Grabens (3) mit einer thermisch gewachsenen Dioxidschicht (4) bedeckt, die die Seitenwand-Dioxidschicht (7') enthält und auf die eine Siliziumnitridschicht (4') aufgebracht wird (Fig.2);
   c) anschließend erfolgt eine anisotrope Nitridätzung, wodurch nichtmaskierte Teile der Siliziumnitridschicht (4') auf der Hauptfläche des Halbleitersubstrats (2) und der Bodenfläche des Grabens (3) entfernt werden;
   d) dann erfolgt eine Dioxidätzung zur Freilegung von nichtmaskierten Teilen der Dioxidschicht, wodurch die Bodenfläche des Grabens (3) und nichtmaskierte Oberflächenteile der Hauptfläche freigelegt werden (Fig. 3);
   e) danach werden in die freiliegenden Teile der Halbleiteroberfläche Ionen des Substrat-Leitungstyps implantiert, welche am Boden des Grabens bei Aktivierung eine Kanalunterbrecherzone (9) und gleichzeitig die Basiszone (5, 5') des Bipolartransistors bilden (Fig. 4);
   f) anschließend erfolgt eine thermische Oxidation, so daß auf dem freiliegenden Silizium an der Bodenfläche des Grabens (3) eine Isolierschicht (8) gebildet wird, deren Dicke größer als die Dicke der Seitenwandoxidschicht (7') ist (Fig. 5);

g) dann wird eine Nitridätzung durchgeführt und die relativ dünne Seitenwanddioxidschicht (7') durch Ätzen entfernt, wobei der Isolierschicht (8) am Boden des Grabens (3) im wesentlichen erhalten bleibt (Fig. 6);

h) anschließend wird eine polykristalline Siliziumschicht des Leitungstyps der Kollektorzone (1) aufgebracht;

i) dann wird durch anisotrope Ätzung das dotierte polykristalline Silizium auf der Bodenfläche des Grabens (3) und auf der Hauptfläche bis auf maskierte Bereiche entfernt, so daß bei einem folgenden Hochtemperaturprozeß an der die Kollektorzone (1) begrenzenden Seitenwand des Grabens (3) ein Kollektorkontakt (6) gebildet wird, der eine in der angrenzenden Seitenfläche der Kollektorzone (1) ausgebildete Kontaktierungszone (7) vom Leitungstyp der Kollektorzone bedeckt (Fig.7).

4. Verfahren nach Anspruch 3, gekennzeichnet durch folgende Verfahrensschritte:

b') nach dem Verfahrensschritt b) wird der Emitterbereich (41) gegen einen Ätzangriff mittels einer Maskierungsschicht (M1) maskiert;

c') danach erfolgen die Verfahrensschritte c) und d), wobei das Halbleitermaterial sowohl an der Bodenfläche des Grabens (3) als auch an der Hauptfläche des Halbleitersubstrats (2) um den Emitterbereich (41) und den Kollektorkontaktbereich freigelegt wird;

d') dann wird die Maskierungsschicht (M1) entfernt;

e') anschließend werden beim Verfahrensschritt e) in beliebiger Reihenfolge die Ionen des Substratleitungstyps das eine Mal bei einer solchen ersten Beschleunigungsspannung implantiert, daß die Schichtenfolge Oxidschicht (4) mit Nitridschicht (4') durchdrungen wird, und das andere Mal bei einer solchen zweiten Beschleunigungsspannung implantiert, daß die Schichtenfolge (4, 4') auf dem Emitterbereich und dem Kollektorkontaktbereich (41) maskiert;

f') anschließend erfolgt der Verfahrensschritt f) der thermischen Oxidation, so daß auf der Bodenfläche des Grabens (3) und auf der Hauptfläche des Halbleitersubstrats (2), außerhalb des Emitterbereichs (41) sowie des Kollektorkontaktbereichs je eine Isolierschicht (8, 81) gebildet wird;

g') dann erfolgt der Verfahrensschritt g), wobei außer der Isolierschicht (8) am Boden des Grabens (3) die auf der Hauptfläche des Halbleitersubstrats (2) außerhalb des Emitterbereichs (41) und außerhalb des Kollektorkontaktbereichs gebildete Isolierschicht (81) erhalten bleibt;

h') danach erfolgt nach Entfernung der noch verbleibenden Bereiche der Schichtenfolge (4, 4') das Aufbringen der polykristallinen Siliziumschicht nach Verfahrensschritt h), und

i') der Verfahrensschritt i) wird unter Verwendung einer Ätzmaske (M2) ausgeführt, welche auf der Hauptfläche einen Kontaktierungsbereich (6') der Kollektorelektrode und die Emitterelektrode (10) definiert, welche den Rand der außerhalb des Emitterbereichs (41) gebildeten Isolierschicht (81) überlappt, so daß bei einem folgenden Hochtemperaturprozeß außer dem Kollektorkontakt (6) mit angrenzender Kontaktierungszone (7) auch der Kontaktierungsbereich (6') der Kollektorelektrode sowie die Emitterelektrode (10) mit angrenzender Emitterzone (11) gebildet werden.

**Claims**

1. Integrated bipolar transistor whose collector region (1) of one conductivity type at one major surface of a semiconductor substrate (2) of silicon of the other conductivity type is insulated from the other components of a solid-state monolithic integrated circuit by means of a moat (3) surrounding the collector region (1), and has a collector contact (6), <u>characterized in</u>

   - that the collector contact (6) of the collector region (1) is disposed at the sidewall of the moat (3) bounding the collector region and is formed by a layer of polycrystalline silicon of the conductivity type of the collector region (1),
   - that the collector contact (6) covers a highly doped contact region (7) formed in the side surface of the collector region (1) and being of the conductivity type of the collector region (1),
   - that the bottom surface of the moat (3) is covered with a silicon-dioxide layer (8), and
   - that the depth of the moat (3) is at least equal to the thickness of the collector region (1).

2. A bipolar transistor as claimed in claim 1, characterized in that directly below the silicon-dioxide layer (8), an interconnection track (12) of doped polycrystalline silicon is provided which is disposed on an additional silicondioxide layer (8') which surrounds the interconnection track (12) together with the silicondioxide layer (8) covering the bottom surface of the moat (3) (Fig. 9).

3. Method of manufacturing an integrated bipolar transistor as claimed in claim 1 or 2 which comprises the following steps:

a) After formation of a single-crystal silicon layer of one conductivity type at one major surface of the semiconductor substrate (2) of the other conductivity type, a moat (3) is formed by isotropically etching through the silicon layer, exposing the side surface of the collector region (1) (Fig. 1);

b) thereafter, the parts of the major surface of the semiconductor substrate (2), including the surface parts of the moat (3), are covered with a thermally grown dioxide layer (4) which includes the sidewall dioxide layer (7') and over which a silicon-nitride layer (4') is deposited (Fig. 2);

c) next, an anisotropic nitride-etching step is performed whereby nonmasked portions of the siliconnitride layer (4') on the major surface of the semiconductor substrate (2) and on the bottom surface of the moat (3) are removed;

d) then, a dioxide-etching step is performed to expose nonmasked portions of the dioxide layer, whereby the bottom surface of the moat (3) and nonmasked parts of the major surface are exposed (Fig. 3);

e) thereafter, ions of the conductivity type of the substrate are implanted into the uncovered parts of the semiconductor surface and, upon activation, form a channel-interrupting region (9) at the bottom of the moat and, at the same time, the base region (5, 5') of the bipolar transistor (Fig. 4);

f) next, a thermal oxidation is carried out to form on the uncovered silicon at the bottom surface of the moat (3) an insulating layer (8) whose thickness is greater than the thickness of the sidewall dioxide layer (7') (Fig. 5);

g) then, a nitride-etching step is performed and the relatively thin sidewall dioxide layer (7') is removed by etching, with the insulating layer (8) at the bottom of the moat (3) being essentially preserved (Fig. 6);

h) next, a polycrystalline silicon layer of the conductivity type of the collector region (1) is deposited, and

i) then, the doped polycrystalline silicon on the bottom surface of the moat (3) and on the major surface is removed by anisotropic etching except in masked areas, so that in a subsequent high-temperature process, a collector contact (6) is formed at the sidewall of the moat (3) bounding the collector region (1), said collector contact (6) covering a contact region (7) which was formed in the adjacent side surface of the collector region (1) and is of the conductivity type of the collector region (Fig. 7).

4. A method as claimed in claim 3, characterized by the following steps:

b') After step b), the emitter area (41) is protected from etching by means of a masking layer (M1);

c') this is followed by steps c) and d), with the semiconductor material being exposed both at the bottom surface of the moat (3) and at the major surface of the semiconductor substrate (2) around the emitter area (41) and the collector contact area;

d') then, the masking layer (M1) is removed;

e') next, in step e), in arbitrary order, the ions of the conductivity type of the substrate are implanted at one time at such a first acceleration voltage that the layer sequence consisting of the oxide layer (4) and the nitride layer (4') is penetrated, and at another time at such a second acceleration voltage that the layer sequence (4, 4') on the emitter area and the collector contact area (41) acts as a mask;

f') next, the thermal-oxidation step f) is carried out to form an insulating layer (8) on the bottom surface of the moat (3) and an insulating layer (81) on the major surface of the semiconductor substrate (2) outside the emitter area (41) and the collector contact area;

g') then, step g) is performed, leaving, besides the insulating layer (8) at the bottom of the moat (3), the insulating layer (81) formed on the major surface of the semiconductor substrate (2) outside the emitter area (41) and outside the collector contact area;

h') then, after removal of the remaining portions of the layer sequence (4, 4'), the polycrystalline silicon layer is deposited in step h), and

i') step (i) is performed using an etch mask (M2) which defines on the major surface a contact area (6') of the collector electrode and the emitter electrode (10), which overlaps the edge of the insulating layer (81) formed outside the emitter area (41), so that in a subsequent high-temperature process, besides the collector contact (6) with the adjacent contact region (7), the contact area (6') of the collector electrode as well as the emitter electrode (10) with on adjacent emitter region (11) are formed.

**Revendications**

1. Transistor bipolaire intégré, dont la zone de collecteur (1) possédant un premier type de conductivité est isolée, au niveau d'une surface principale d'un substrat semiconducteur en forme de disque (2) en silicium possédant l'autre type de conductivité, par rapport aux autres composants d'un circuit à corps solide intégré monolithique, au moyen d'un sillon (3) qui entoure complètement la zone de collecteur (1), et comporte un contact de collecteur (6), caractérisé par le fait

- que le contact de collecteur (6) de la zone de collecteur (1) est disposé au niveau de la paroi latérale, qui limite la zone de collecteur, du sillon (3) et est constitué par une couche formée de silicium polycristallin possédant le type de conductivité de la zone de collecteur (1),
- que le contact de collecteur (6) recouvre une zone de contact (7) fortement dopée, qui est ménagée dans la surface latérale de la zone de collecteur (1) et possède le type de conductivité de cette dernière,
- que la surface du fond du sillon (3) est recouverte par une couche de bioxyde de silicium (8), et
- que la profondeur du sillon (3) est au moins égale à l'épaisseur de la zone de collecteur (1).

2. Transistor bipolaire suivant la revendication 1, caractérisé par le fait

- que directement au-dessous de la couche de bioxyde de silicium (8) est disposée une voie conductrice (12) formée de silicium polycristallin dopé, qui est disposée sur une autre couche de bioxyde de silicium (8') qui, conjointement avec la couche de bioxyde de silicium (8) présente sur la surface du fond du sillon (3), entoure la voie conductrice (12) (figure 9).

3. Procédé pour fabriquer un transistor bipolaire intégré selon la revendication 1 ou 2 et qui comprend les étapes opératoires suivantes :

a) après formation d'une couche de silicium monocristallin possédant le premier type de conductivité sur une surface principale du substrat semiconducteur (2) possédant l'autre type de conductivité, on aménage un sillon (3) au moyen d'une corrosion anisotrope à travers la couche de silicium et on met à nu la surface latérale de la zone de collecteur (1) (figure 1);

b) ensuite, on recouvre les parties superficielles de la surface principale du substrat semiconducteur (2), y compris les parties superficielles du sillon (3), avec une couche de bioxyde (4) formée par croissance thermique, qui comprend la couche de bioxyde de paroi latérale (7') et est déposée sur une couche de nitrure de silicium (4') (figure 2);

c) puis on réalise une corrosion anisotrope du nitrure de manière à éliminer des parties non masquées de la couche de nitrure de silicium (4') sur la surface principale du substrat semiconducteur (2) et la surface du fond du sillon (3);

d) on exécute ensuite une corrosion du dioxyde pour mettre à nu des parties non masquées de la couche de dioxyde, de manière à mettre à nu la surface du fond du sillon (3) et des parties superficielles non masquées de la surface principale (figure 3);

e) puis on implante, dans les parties mises à nu de la surface du semiconducteur, des ions possédant le type de conductivité du substrat et qui forment, dans le fond du sillon, lors de l'activation, une zone d'interruption de canal (9) et simultanément la zone de base (5,5') du transistor bipolaire (figure 4);

f) on exécute ensuite une oxydation thermique afin de former, sur le silicium mis à nu, au niveau de la surface du fond du sillon (3), une couche isolante (8) dont l'épaisseur est supérieure à l'épaisseur de la couche d'oxyde de paroi latérale (7') (figure 5);

g) puis on exécute une corrosion du nitrure et on élimine par corrosion la couche relativement mince de bioxyde (7') de paroi latérale, la couche isolante (8) subsistant pour l'essentiel au fond du sillon (3) (figure 6);

h) ensuite, on dépose une couche de silicium polycristallin possédant le type de conduction de la zone de collecteur (1);

i) on élimine ensuite, au moyen d'une corrosion anisotrope, le silicium polycristallin dopé sur la surface du fond du sillon (3) et sur la surface principale en dehors de zones masquées, de sorte que lors d'un traitement thermique ultérieur à haute température, il se forme, au niveau de la paroi latérale du sillon (3), qui limite la zone de collecteur (1), un contact de collecteur (6), qui recouvre une zone de contact (7), qui est formée dans la surface latérale contiguë de la zone de collecteur (1) et possède le type de conductivité de la zone de collecteur (figure 7).

4. Procédé selon la revendication 3, caractérisé par les étapes opératoires suivantes :

b') après l'étape opératoire b), on masque la zone d'émetteur (41) pour la protéger d'une attaque par corrosion, au moyen d'une couche de masquage (M1);

c') ensuite on exécute les étapes opératoires c) et d), ce qui met à nu le matériau semiconducteur aussi bien au niveau de la surface du fond du sillon (3) que, également, au niveau de la surface principale du substrat semiconducteur (2), autour de la zone d'émetteur (41) et de la zone de contact de collecteur;

d') on retire ensuite la couche de masquage (M1);

e') ensuite, lors de l'étape opératoire e), on implante, selon une succession quelconque, les ions possédant le type de conductivité du substrat, une fois avec une première tension accélératrice telle que la suite de couches formée par la couche d'oxyde (4) et la couche de nitrure (4') est traversée, et une autre fois avec une second tension accélératrice telle que la suite de couches (4,4') réalise un masquage sur la zone d'émetteur et sur la zone de contact du collecteur (41)

f') puis on exécute l'étape opératoire f) d'oxydation thermique de manière à former, sur la surface du fond du sillon (3) et sur la surface principale du substrat semiconducteur (2), à l'extérieur de la zone d'émetteur (41) ainsi que de la zone de contact de collecteur, des couches isolantes respectives (8,81);

g') on exécute ensuite l'étape opératoire g), auquel cas, en dehors de la couche isolante (8) présente dans le fond du sillon (3) subsiste la couche isolante (81) formée sur la surface principale du substrat semiconducteur (2) à l'extérieur de la zone d'émetteur (41) et à l'extérieur de la zone de contact de collecteur;

h') puis, après élimination des zones, qui subsistent encore, de la suite de couches (4,4'), on exécute le dépôt de la couche de silicium polycristallin selon l'étape opératoire h), et

i') on exécute l'étape opératoire i) en utilisant un masque de corrosion (M2), qui définit, sur la surface principale, une zone de contact (6') de l'électrode de collecteur et l'électrode d'émetteur (10), qui recouvre le bord de la couche isolante (81) formée à l'extérieur de la zone d'émetteur (41), de sorte que, lors d'un traitement thermique ultérieur à haute température, également la zone de contact (6') de l'électrode de collecteur ainsi que l'électrode d'émetteur (10) et la zone d'émetteur contiguë (11) sont formées, en plus du contact de collecteur (6) et de la zone de contact contiguë (7).

# FIG. 1

# FIG. 2

# FIG.3

FIG. 4

FIG. 5

FIG. 6

FIG.7

FIG.8

FIG.9